Europäisches Patentamt

European Patent Office

Office européen des brevets

(19)

(11) Veröffentlichungsnummer: **0 025 074**
**B1**

(12) # EUROPÄISCHE PATENTSCHRIFT

(45) Veröffentlichungstag der Patentschrift:
17.08.83

(21) Anmeldenummer: 79200540.7

(22) Anmeldetag: 26.09.79

(51) Int. Cl.³: **H 03 K 17/72, H 02 M 1/06,
H 01 L 27/06, H 01 L 29/743**

(54) Verfahren zum Löschen eines Thyristors und Halbleiterbaustein zur Ausführung des Verfahrens.

(30) Priorität: 31.08.79 CH 7894/79

(43) Veröffentlichungstag der Anmeldung:
18.03.81 Patentblatt 81/11

(45) Bekanntmachung des Hinweises auf die Patenterteilung:
17.08.83 Patentblatt 83/33

(84) Benannte Vertragsstaaten:
CH DE FR GB NL

(56) Entgegenhaltungen:
**DE-A-2 653 431
DE-B-1 276 713
DE-B-2 060 743
US-A-3 694 670
Patents Abstracts of Japan Band 3, Nr. 58, 18. Mai
1979, Seite 134 E 111**

(73) Patentinhaber: **BBC Aktiengesellschaft Brown, Boveri &
Cie., Haselstrasse, CH-5401 Baden (CH)**

(72) Erfinder: **Roggwiller, Peter, Dr., Puentstrasse 712,
CH-8173 Neerach-Riedt (CH)**
Erfinder: **Sittig, Roland, Dr., Rinikerstrasse 102,
CH-5222 Umiken (CH)**

### Verfahren zum Löschen eines Thyristors und
### Halbleiterbaustein zur Ausführung des Verfahrens

Die vorliegende Erfindung betrifft ein Verfahren zum Löschen eines Thyristors mit Hilfe mindestens einer dem Thyristor antiparallel geschalteten Halbleiterdiode, bei welchem Verfahren diese Diode während einer Zeitspanne, die mindestens der durch die Eigenschaften und die Betriebsweise des Thyristors bedingten Freiwerdezeit des Thyristors entspricht, den Laststrom des Thyristors übernimmt, sowie einen Halbleiterbaustein zur Ausführung dieses Verfahrens und eine Verwendung desselben. Ein derartiges Verfahren ist aus der DE-B-2 060 743 bekannt.

Thyristoren sind Siliziumhalbleiterventile, die wegen ihrer langen Lebensdauer, Wartungsfreiheit und Unempfindlichkeit gegen Erschütterungen sowohl in der Signal- als auch in der Leistungselektronik vielfältig verwendet werden, beispielsweise in Regelschaltungen mit steuer- bzw. regelbarer Ausgangsspannung usw. Der Thyristor kann mit einem an das Gate geführten Steuerimpuls geringer Leistung in den stromleitenden Zustand geschaltet werden, dagegen ist es nicht möglich, den zwischen der Anode und der Kathode fließenden Laststrom mit einem Steuersignal am Gate zu unterbrechen. Dazu muß der Laststrom unter den Haltestrom absinken, was bei Wechselstrombetrieb am Ende jeder positiven Halbwelle zwangsläufig erfolgt und wofür zum gesteuerten Stromunterbruch zusätzliche Löschschaltungen erforderlich sind. Dem Fachmann sind verschiedene Ausführungsformen von Lösch- oder Abkommutierschaltungen bekannt, die oft aufwendiger sind als der Thyristorlastkreis.

Es ist darum schon ein Verfahren zum Löschen eines Thyristors vorgeschlagen worden, das mit wesentlich geringerem schaltungstechnischen Aufwand ausgeführt werden kann. Bei diesem Verfahren wird der Laststrom des Thyristors während der erforderlichen Freiwerdezeit auf ein antiparallel geschaltetes Bauelement kommutiert. Das Bauelement ist vorzugsweise eine Halbleiterdiode, deren Kathode direkt mit der Anode und deren Anode über die Sekundärwicklung eines Übertragers mit der Kathode des Thyristors verbunden ist. Zum Löschen des Thyristors wird in dieser Sekundärwicklung ein Stromimpuls erzeugt, der durch die Diode fließt und dem Laststrom im Thyristor überlagert wird. Dieser Stromimpuls wirkt als Aufladestrom, der die Basis der Diode mit Ladungsträgern überschwemmt, so daß die Diode bei der durch die Schaltinduktivität bewirkten Umkehrung des Stromimpulses den dazugehörenden Rückwärtsstrom und den Laststrom des Thyristors übernimmt.

Zur Ausführung dieses Verfahrens sind mindestens zwei Bedingungen zu erfüllen. Die Induktivität des Dioden-Thyristorkreises muß sehr klein sein, damit der Rückwärtsstrom durch die Diode einsetzt, bevor die Sperrverzögerungsladung rekombiniert ist, und der Aufladestromimpuls muß wesentlich größer sein als der Momentanwert des abzuschaltenden Laststroms, damit der rückwärtige Strom diesen Laststrom auf die Diode kommutieren kann. Diese Bedingungen und der Umstand, daß der Aufladestrom in der Vorwärtsrichtung dem Laststrom im Thyristor überlagert wird, haben die Anwendung dieses Verfahrens bisher auf einige spezielle Schaltungen beschränkt.

Der vorliegenden Erfindung liegt darum die Aufgabe zugrunde, ein Verfahren zum Löschen eines Thyristors zu schaffen, bei dem der Dioden-Thyristorkreis keine die Abschaltzeit verzögernde Übertragerinduktivität aufweist, bei dem der Thyristor nicht mit einem zusätzlichen Aufladestrom belastet wird und das mit vergleichsweise geringem schaltungstechnischen Aufwand ausgeführt werden kann.

Erfindungsgemäß wird diese Aufgabe mit einem Verfahren der eingangs genannten Art gelöst, das dadurch gekennzeichnet ist, daß in der Halbleiterdiode durch Bestrahlung ein Strom erzeugt wird, dessen Stromstärke mindestens so groß ist wie der Momentanwert des Laststroms und der an den Außenanschlüssen der Halbleiterdiode eine Spannungsdifferenz erzeugt, die kleiner ist als der Spannungsabfall des stromleitenden Thyristors.

Bei dem neuen Verfahren fließt der zu erzeugende Strom in der gleichen Richtung wie der Laststrom im Thyristor. Es ist darum keine Schwingung des Aufladestroms zur Richtungsumkehr erforderlich. Das hat den Vorteil, daß der Thyristor nicht zusätzlich mit dem Aufladestrom belastet wird, daß der Strom nicht wesentlich größer sein muß als der zu kommutierende Laststrom, daß die Kommutierung nicht durch die Schwingzeit des Aufladestroms verzögert wird und daß der Thyristor-Halbleiterdiodekreis keine Induktivität aufweisen muß. Außerdem kann das neue Verfahren als potentialfreies Verfahren ausgeführt werden, wenn die Einrichtung zum Auslösen des Stroms elektrisch vom Laststrom getrennt wird.

Vorzugsweise wird der Strom in dem Halbleiterbauelement durch eine elektromagnetische Strahlung oder Elektronenbestrahlung erzeugt.

Ein zur Ausführung des neuen Verfahrens geeigneter Halbleiterbaustein enthält in integrierter Anordnung den Thyristor und mindestens eine antiparallel geschaltete Diode. Vorzugsweise ist dieses Bauelement als Fotodiode mit einer p-n-Struktur ausgebildet, deren Sperrspannung mindestens gleich groß wie die des Thyristors ist.

Nachfolgend werden einige Ausführungsformen der Erfindung mit Hilfe der Figuren beschrieben.

Es zeigt

Fig. 1 die Prinzipschaltung eines Thyristors und einer Halbleiterdiode zur Ausführung des neuen Verfahrens,

Fig. 2 die schematische Darstellung eines Halbleiterbausteins mit integrierter Anordnung eines Thyristors und einer Halbleiterdiode,

Fig. 3 die schematische Darstellung eines Halbleiterbausteins mit integrierter planarer Anordnung eines Thyristors und einer Halbleiterdiode,

Fig. 4 die schematische Darstellung eines Halbleiterbausteins gemäß der Fig. 2, der in einer Elektronenröhre angeordnet ist und

Fig. 5 ein Oszillogramm mit den Spannungs- und Stromverläufen beim erfindungsgemäßen Löschen eines Thyristors.

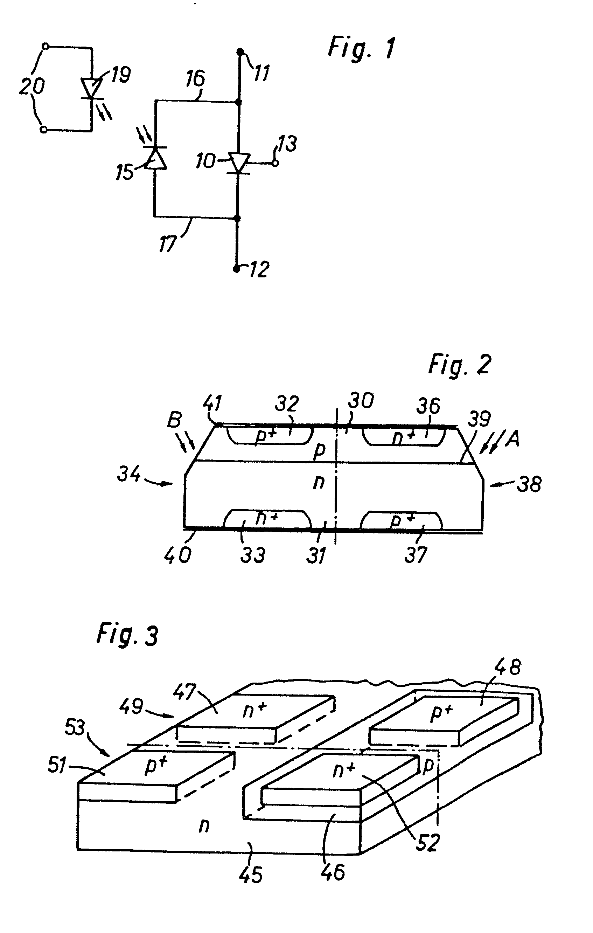

Die Fig. 1 zeigt eine Prinzipschaltung zur Ausführung des neuen Verfahrens. Die Schaltung enthält einen Thyristor 10, dessen Anode und Kathode mit den Anschlußklemmen 11 bzw. 12 einer Laststromleitung und dessen Gate mit der Anschlußklemme 13 eines Zünd- oder Steuerkreises verbunden ist. Die Schaltung enthält weiter eine Halbleiterdiode 15, deren Kathode über eine Leitung 16 mit der Anode und deren Anode über die Leitung 17 mit der Kathode des Thyristors verbunden ist. Weiter ist eine Lichtquelle 19 vorgesehen, der ein nicht gezeigter Erregerkreis 20 zugeordnet ist. Die Lichtquelle und die Halbleiterdiode sind miteinander ausgerichtet, so daß das von der Lichtquelle erzeugte Licht auf die lichtempfindliche Fläche der Diode fällt.

Zur Beschreibung der Arbeitsweise dieser Schaltung sei angenommen, daß der Thyristor durch einen geeigneten Zündimpuls an der Anschlußklemme 13 in den leitfähigen Zustand geschaltet wurde und ein Laststrom von der Anschlußklemme 11 durch den Thyristor zur Anschlußklemme 12 fließt. Die Durchlaßspannung des Thyristors, d. h. der Spannungsabfall zwischen der Anorde und der Kathode, beträgt dann etwa 1 bis 2 Volt. Die gleiche Spannung liegt dann an der antiparallel geschalteten Halbleiterdiode. Zum Löschen des Thyristors wird die Lichtquelle erregt, wobei das auf die Halbleiterdiode fallende Licht in der Diode einen Fotostrom erzeugt, der die Sperrschicht in der Diode überschwemmt, so daß die Sperrspannung nur noch etwa 0,5 Volt beträgt. Sobald die Sperrspannung im Parallelzweig kleiner ist als die Durchlaßspannung des Thyristros, kommutiert der Laststrom in den Parallelzweig, und der Thyristor sperrt, sobald der Strom im Thyristorzweig unter den Haltestrom abgesunken ist.

Für die beschriebene Arbeitsweise ist erforderlich, daß die Sperrspannung der belichteten Diode kleiner ist als die Durchlaßspannung des Thyristors, daß der Fotostrom mindestens so groß ist wie der Laststrom zum Zeitpunkt des Kommutierens und daß in der Diode genügend Ladungsträger freigesetzt werden, damit der Laststrom während der gesamten Freiwerdezeit des Thyristors durch die Diode fließen kann. Die letztere Bedingung kann auf zweierlei Weise erfüllt werden: Erzeugen eines Fotostroms während der gesamten Freiwerdezeit oder kurzzeitiges Erzeugen eines Ladungsträgerreservoirs, dessen Lebensdauer mindestens gleich der Freiwerdezeit des Thyristors ist. Die letztere Betriebsweise setzt jedoch voraus, daß die durch die Induktivität des Thyristor-Diodenkreises bewirkte Verzögerung des Kommutierens klein ist gegenüber der Lebensdauer des Ladungsträgerreservoirs.

Die Fig. 2 zeigt in schematischer Darstellung einen für die Ausführung des neuen Verfahrens vorgesehenen Halbleiterbaustein. Der Baustein enthält eine Basiszone mit einer p- und einer n-leitenden Schicht 30, 31. Auf der einen (in der Figur linken) Seite des Bausteins ist in der p-Schicht 30 der Basis eine p+-Anodenzone 32 und in dem gegenüberliegenden Bereich der n-Schicht 31 eine n+-Kathodenzone 33 eingebaut. Diese Schichtenfolge bildet eine Diode 34. Auf der anderen (in der Figur rechten) Seite des Bausteins ist in die p-Schicht 30 eine n+-Kathodenzone 36 und im gegenüberliegenden Bereich der n-Schicht 31 eine p+-Anodenzone 37 eingebaut, welche Schichtenfolge einen Thyristor 38 bildet. Die benachbarten Anoden- und Kathodenzonen 37 bzw. 33 ebenso wie die benachbarten Kathoden- und Anodenzonen 36 bzw. 32 des Thyristors bzw. der Diode sind mittels metallisch leitender Kontaktschichten 40 bzw. 41 miteinander verbunden.

Der beschriebene Baustein hat den Vorteil, daß der Thyristor 38 durch Energieeinstrahlung in den Bereich A, d. h. potentialfrei, gezündet und durch ebenfalls potentialfreie Energieeinstrahlung in den Bereich B der Sperrschicht 39 der Diode 34 gelöscht werden kann. Ein weiterer Vorteil ist die vernachlässigbar kleine Induktivität der durch die Kontaktschichten 40 bzw. 41 gebildeten Verbindungsleitungen, die das praktisch unverzögerte Kommutieren des Laststroms vom Thyristor auf die Diode ermöglicht. Das potentialfreie Zünden und Löschen des Thyristors und das praktisch verzögerungsfreie Kommutieren des Laststroms ermöglichen den Einsatz dieses Bausteins insbesondere in der Signalelektronik, wo relativ kleine Lastströme verwendet werden, aber sehr rasche Schaltzeiten gefordert sind.

Die Fig. 3 zeigt ebenfalls in schematischer Darstellung einen für die Ausführung des neuen Verfahrens vorgesehenen Halbleiterbaustein, der im Gegensatz zum Baustein gemäß der Fig. 2 in Planartechnik ausgeführt ist. Dieser Baustein enthält eine Scheibe 45 aus einem n-leitenden Material, in die eine erste p-leitende Schicht 46 eindiffundiert ist und mit dieser Schicht die Basiszone bildet. Weiter sind (in dem in der Figur hinteren Teil des Bausteins) in die n-leitende Scheibe eine n+-Zone 47 und in die p-leitende Schicht eine p+-Zone 48 eindiffundiert, welche die Kathoden- bzw. Anodenzone einer Diode 49 bilden. In dem in der Figur vorderen Teil des Bausteins sind in die n-leitende Scheibe eine p+-Zone 51 und in die p-leitende Schicht 46 eine n+-Zone eindiffundiert, welche die Anoden- bzw. Kathodenzone eines Thyristors 53 bilden.

Der einfacheren Darstellung wegen sind bei diesem Baustein die Kontaktschichten nicht gezeigt.

Es versteht sich, daß bei diesem Baustein die einzelnen Zonen in beliebig andere als den schematisch gezeigten kubischen Konfigurationen angeordnet sein können und daß der Baustein ähnliche Eigenschaften und Vorteile wie der Baustein gemäß der Fig. 2 aufweist.

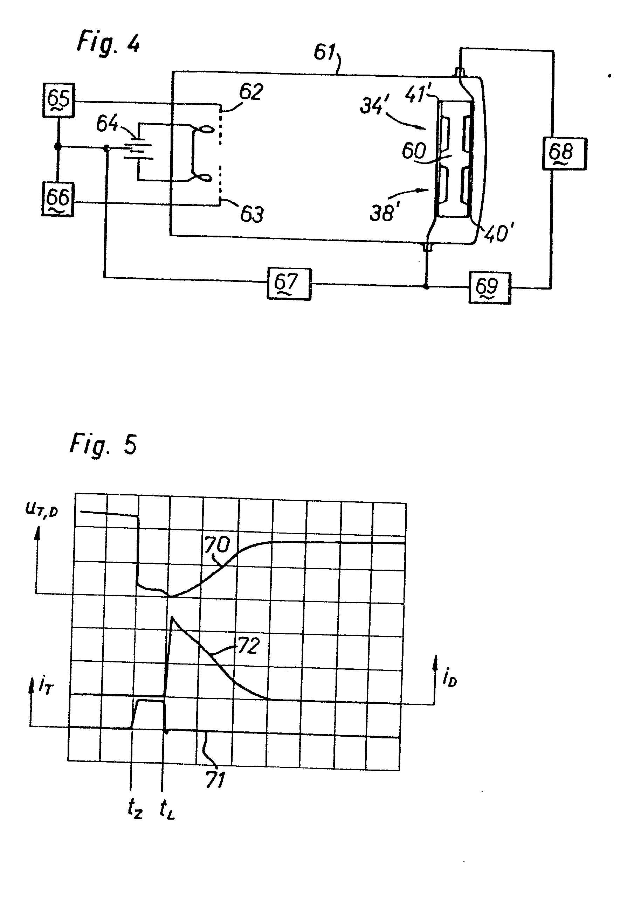

Die Fig. 4 zeigt die Verwendung eines Bausteins gemäß der Fig. 2, wobei anstelle der Steuerung durch Licht eine Steuerung durch Bestrahlen mit Elektronen vorgesehen ist. Dazu ist der Baustein 60 als Anode in einer Elektronenröhre 61 eingesetzt. Die gezeigte Röhre weist zwei unabhängig ansteuerbare Steuergitter 62, 63 auf, die mit Steuerschaltungen 65 bzw. 66 verbunden sind. Der Halbleiterbaustein 60 ist derart angeordnet, daß der vom Gitter 62 gesteuerte Elektronenstrom auf den Diodenteil 34' und der vom Gitter 63 gesteuerte Elektronenstrom auf den Thyristorteil 38' trifft. Die den Steuergittern zugewandte Kontaktschicht 41' ist über eine Einschmelzung mit einer Hochspannungsquelle 67 verbunden, deren anderer Ausgang an den Mittelabgriff einer Stromquelle 64 für die Kathoden geführt ist. Die den Steuergittern abgewandte Kontaktschicht 40' ist über eine andere Einschmelzung mit einem Lastkreis 68 verbunden, der seinerseits über eine Stromquelle 69 mit der Einschmelzung für die den Steuergittern zugewandte Kontaktschicht 41' verbunden ist.

Beim Betrieb der Schaltung wird durch kurzes Auftasten des Steuergitters 63 der Thyristor 38' gezündet, und es fließt ein Strom von der Stromquelle 69 durch den Thyristor und den Lastkreis 68. Beim Auftasten des Steuergitters 62 werden in der Diode 39' Ladungsträger erzeugt, die die Sperrschicht der Diode überschwemmen und eine Sperrverzögerungsladung bilden, derzufolge die Sperrspannung der Diode auf einen Wert absinkt, der kleiner ist als die Durchlaßspannung des Thyristors, so daß der Laststrom vom Thyristor auf die Diode kommutiert. Auch bei dieser Schaltung ist es möglich, die Diode wahlweise während der gesamten Freiwerdezeit des Thyristors mit Elektronen zu bestrahlen, die dann einen zur Übernahme des Laststroms geeigneten Strom erzeugt, oder die Diode nur während einer kurzen Zeitspanne mit ausreichend Elektronen zu bestrahlen, damit in der Sperrschicht ein Ladungsträgerreservoir erzeugt wird, dessen Lebensdauer etwa der Freiwerdezeit des Thyristors entspricht.

Zum Verifizieren des neuen Verfahrens wurde eine Schaltung aufgebaut, die das Messen des zeitlichen Verlaufs von Strom und Spannung durch bzw. am Thyristor während des Zündens und Löschens ermöglicht. Die Schaltung enthielt einen $16\mu$F-Kondensator, der über einen 50-$\Omega$-Ladewiderstand mit einer 50-V-Gleichstromquelle verbunden war. Der Entladekreis des Kondensators bestand aus einem 10-$\Omega$-Lastwiderstand und einem in Serie geschalteten Thyristor. Dem Thyristor war eine zum Löschen vorgesehene Diode antiparallel geschaltet. Als Strahlungsquelle zum Zünden der Diode wurde ein Nd : YAG-Laser verwendet.

Fig. 5 zeigt das Schirmbild eines Oszillographen mit der Kurve 70 für den Spannungsverlauf $U_T$, D über dem Thyristor und der Diode, der Kurve 71 mit dem Stromverlauf $i_T$ durch den Thyristor und der Kurve 72 mit dem Stromverlauf $i_D$ durch die Diode. Die vertikale Auslenkung für die Kurven 70 und 71 betrug 20 V/Teilung bzw. 5 A/Teilung, die vertikale Auslenkung für die Kurve 72 betrug 2 A/Teilung. Die horizontale Auslenkung betrug für alle drei Kurven 20 $\mu$s/Teilung. Aus dem Oszillogramm ist zu erkennen, daß bis zum Zeitpunkt $t_Z$ die Spannung am Thyristor und der Diode praktisch 50 V betrug und weder durch den Thyristor noch durch die Diode ein Strom floß. Zum Zeitpunkt $t_Z$ wurde der Thyristor auf konventionelle Art gezündet. Dann setzte sprunghaft ein Stromfluß ein, der vom Lastwiderstand auf etwa 5 A begrenzt war, und die Spannung über dem Thyristor fiel auf etwa 1,3 Volt ab. Nach 20 $\mu$s, d. h. zum Zeitpunkt $t_L$, wurde die Diode von dem Laser während etwa 0,2 $\mu$s bestrahlt und dabei soviel Ladungsträger erzeugt, daß die Spannung über der Diode und dem Thyristor auf etwa 0,6 V absank und folglich die Diode den Entladestrom von etwa 5 A übernahm. Der Strom durch die Diode nahm wegen der zunehmenden Verarmung an Ladungsträgern kontinuierlich ab, und die Spannung über der Diode und dem Thyristor stieg innert 8 $\mu$s wieder auf den vorherigen Wert von etwa 1,3 Volt an, ohne daß der Thyristor die Stromleitung wieder übernahm. Der Abbau des Ladungsträgerreservoirs in der Diode und folglich auch der Stromfluß durch die Diode dauerte gesamthaft etwa 60 $\mu$s, während welcher Zeit die Spannung am Thyristor und an der Diode auf die nach der Entladung im Kondensator verbleibende Spannung von etwa 35 V anstieg.

Es versteht sich, daß die gezeigte Ausführungsform an besondere Betriebsbedingungen angepaßt werden kann. Beispielsweise können anstelle der gezeigten direkt geheizten Kathoden auch indirekt geheizte Kathoden verwendet werden. Es ist auch möglich, anstelle der gezeigten zwei Elektronenstrahlsysteme nur ein solches System zu verwenden und den Elektronenstrahl elektrostatisch oder magnetisch zu fokussieren und auf den Thyristor oder die Diode zu lenken.

Bezeichnungsliste

| | | |
|---|---|---|
| 10 | = | Thyristor |
| 11, 12, 13 | = | Anschlußklemmen |
| 15 | = | Halbleiterdiode |
| 16, 17 | = | Leitungen |
| 19 | = | Lichtquelle |
| 20 | = | Erregerkreis |
| 30 | = | p-leitende Schicht |
| 31 | = | n-leitende Schicht |

32 = p+-Anodenzone
33 = n+-Kathodenzone
34, 34' = Dioden
36 = n+-Kathodenzone
37. = p+-Anodenzone
38, 38' = Thyristoren
40, 40' = Kontaktschichten
41, 41' = Kontaktschichten
45 = Scheibe
46 = p-leitende Schicht
47 = n+-Zone
48 = p+-Zone
51 = p+-Zone
52 = n+-Zone
53 = Thyristor
60 . = Halbleiterbaustein
61 = Elektronenröhre
62, 63 = Steuergitter
64 = Stromquelle
65, 66 = Steuerschaltungen
67 = Hochspannungsquelle
68 = Lastkreis
69 = Stromquelle
70, 71, 72 = Kurven

## Patentansprüche

1. Verfahren zum Löschen eines Thyristors mit Hilfe mindestens einer dem Thyristor (10; 38; 38'; 53) antiparallel geschalteten Halbleiterdiode (15; 34; 34'; 49), bei welchem Verfahren diese Diode während einer Zeitspanne, die mindestens der durch die Eigenschaften und die Betriebsweise des Thyristors bedingten Freiwerdezeit des Thyristors entspricht, den Laststrom des Thyristors übernimmt, dadurch gekennzeichnet, daß in der Halbleiterdiode durch Bestrahlung ein Strom erzeugt wird, dessen Stromstärke mindestens so groß ist wie der Momentanwert des Laststroms und der an den Außenanschlüssen der Halbleiterdiode eine Spannungsdifferenz erzeugt, die kleiner ist als der Spannungsabfall des stromleitenden Thyristors.

2. Verfahren nach Anspruch 1, dadurch gekennzeichnet, daß der Strom durch eine elektromagnetische Strahlung erzeugt wird.

3. Verfahren nach Anspruch 2, dadurch gekennzeichnet, daß ein zur Lichtzündung geeigneter Thyristor und eine Foto-Halbleiterdiode verwendet werden und zum Zünden wie zu dem durch Erzeugen des Stroms in der Foto-Halbleiterdiode bewirkten Löschen des Thyristors je ein Lichtimpuls verwendet wird.

4. Verfahren nach Anspruch 1, dadurch gekennzeichnet, daß die Halbleiterdiode zum Erzeugen des Stroms mit Elektronen bestrahlt wird.

5. Verfahren nach Anspruch 4, dadurch gekennzeichnet, daß ein Thyristor verwendet wird, der durch Bestrahlung mit Elektronen gezündet werden kann und zum Zünden wie zu dem durch Erzeugen des Stroms in der Halbleiterdiode bewirkten Löschen des Thyristors je ein Elektronenstromimpuls verwendet wird.

6. Halbleiterbaustein zur Ausführung des Verfahrens gemäß Anspruch 1, gekennzeichnet durch die integrierte Anordnung eines Thyristors (38) und mindestens einer antiparallel geschalteten Halbleiterdiode (34).

7. Halbleiterbaustein nach Anspruch 6, dadurch gekennzeichnet, daß die Sperrspannung der Halbleiterdiode (34; 49) mindestens so hoch wie die Sperrspannung des zugeordneten Thyristors (38; 53) ist.

8. Verwendung des Halbleiterbausteins nach Anspruch 6 als Anode in einer Elektronenröhre (61) mit zwei unabhängig ansteuerbaren Steuergittern (62, 63).

## Claims

1. A method for turning off a thyristor with the aid of at least one semi-conductor diode (15; 34; 34'; 49) which is connected anti-parallel to the thyristor (10; 38; 38'; 53), in which method this diode handles the load current of the thyristor during a period of time which corresponds at least to the circuit-commutated turn-off time, which is a function of its properties and method of operation, of the thyristor, characterised in that in the semi-conductor diode a current is generated by irradiation, the current intensity of which current is at least as great as the instantaneous value of the load current and which, at the external connections of the semi-conductor diode, generates a voltage difference which is smaller than the voltage drop across the current-conducting thyristor.

2. A method according to Claim 1, characterised in that the current is generated by an electromagnetic radiation.

3. A method according to Claim 2, characterised in that a thyristor which is suitable for photo-ignition and a semi-conductor photodiode are used and that one light pulse each is used for the firing and for the turning-off, effected by generating the current in the semi-conductor photodiode, of the thyristor.

4. A method according to Claim 1, characterised in that for the purpose of generating the current the semi-conductor diode is irradiated with electrons.

5. A method according to Claim 4, characterised in that a thyristor is used which can be fired by being irradiated with electrons and that one electron current pulse each is used for the firing and for the turning-off, effected by generating the current in the semi-conductor diode, of the thyristor.

6. A semi-conductor component for carrying out the method according to Claim 1, characterised by the integrated arrangement of a thyristor (38) and at least one semi-conductor diode (34) in anti-parallel connection.

7. A semi-conductor component according to Claim 6, characterised in that the cut-off voltage of the semi-conductor diode (34; 49) is at least as high as the cut-off voltage of the associated thyristor (38; 53).

8. Use of the semi-conductor component according to Claim 6 as the anode in an electron tube (61) with two independently controllable control grids (62, 63).

**Revendications**

1. Procédé pour éteindre un thyristor au moyen d'au moins une diode semi-conductrice (15, 34, 34', 49) connectée d'une manière antiparallèle au thyristor (10, 38, 38', 53) selon lequel cette diode reprend le courant de charge du thyristor pendant une période qui correspond au moins au temps de récupération du thyristor déterminé par les propriétés et le mode de fonctionnement du thyristor, caractérisé en ce que, dans la diode semi-conductrice on produit par irradiation, un courant dont l'intensité est au moins égale à la valeur momentanée du courant de charge et qui produit aux bornes de la diode semi-conductrice une différence de tension qui est inférieure à la chute de tension du thyristor conducteur.

2. Procédé suivant la revendication 1, caractérisé en ce que le courant est produit par un rayonnement électromagnétique.

3. Procédé suivant la revendication 2, caractérisé en ce qu'on utilise un thyristor pouvant être allumé par de la lumière et une diode photoconductrice et, pour l'allumage de même que pour l'extinction du thyristor provoquée par la production du courant dans la diode photoconductrice, on utilise chaque fois une impulsion lumineuse.

4. Procédé suivant la revendication 1, caractérisé en ce qu'on irradie la diode semi-conductrice au moyen d'électrons pour produire du courant.

5. Procédé suivant la revendication 4, caractérisé en ce qu'on utilise un thyristor qui peut être allumé par irradiation au moyen d'électrons et pour l'allumage de même que pour l'extinction du thyristor provoquée par la production du courant dans la diode semi-conductrice, on utilise chaque fois une impulsion de courant d'électrons.

6. Eléments semi-conducteur destiné à mettre en oeuvre le procédé suivant la revendication 1, caractérisé en ce qu'on utilise un montage intégré d'un thyristor (38) et d'au moins une diode semi-conductrice (34) connectée de manière antiparallèle.

7. Elément semi-conducteur suivant la revendication 6, caractérisé en ce que la tension de blocage de la diode semi-conductrice (34, 49) est au moins égale à la tension de blocage du thyristor (38, 53) associé.

8. Utilisation de l'élément semi-conducteur suivant la revendication 6 comme anode dans un tube électronique (61) comportant deux grilles de commande (62, 63) pouvant être activées indépendamment l'une de l'autre.

**Fig. 1**

**Fig. 2**

**Fig. 3**

## Fig. 4

## Fig. 5